# EUROPÄISCHE PATENTSCHRIFT

(11) **EP 0 409 310 B1**
(45) Veröffentlichungstag und Bekanntmachung des Hinweises auf die Patenterteilung: **29.05.1996**
(21) Anmeldenummer: 90201833.2
(22) Anmeldetag: 09.07.1990
(51) Int. Cl.: G06T 5/00

(54) **Verfahren sowie Anordnung zum Bestimmen von Kanten in Bildern**
Method and apparatus for edge detection in images
Méthode et appareil de détection de contours dans des images

(30) Priorität: 15.07.1989 DE 3923449
(43) Veröffentlichungstag der Anmeldung: 23.01.1991
(73) Patentinhaber: Philips Patentverwaltung GmbH, 22335 Hamburg (DE); Philips Electronics N.V., 5621 BA Eindhoven (NL)
(72) Erfinder: Imme, Martin Walter, D-2000 Hamburg 20 (DE)
(74) Vertreter: Poddig, Dieter, Dipl.-Ing.

(56) Entgegenhaltungen:
- PATENT ABSTRACTS OF JAPAN vol. 12, no. 313 (P-749)(3160) 25. August 1988 & JP-A-63 081 579
- SYSTEMS & COMPUTERS IN JAPAN Bd. 18, Nr. 8, August 1986, Seiten 1165 - 1171; TSUTOMU HORIKOSHI: 'Image Processing Algorithm for Edge-Line Extraction of Limph Vessel Wall and Measurement of the Vessel Diameter'

## Beschreibung

Gemäß dem Oberbegriff des Anspruchs 1 betrifft die Erfindung ein Verfahren zum Bestimmen von Kanten in Bildern, die als Grauwerte von in einer zweidimensionalen Bildmatrix angeordneten Bildpunkten vorliegen, wobei die Grauwertverläufe dieser Bildmatrix mit Hilfe eines Operators gefiltert werden und in der gefilterten Bildmatrix durch Verknüpfung der Grauwerte jeweils mehrerer benachbarter Bildpunkte Kanten bestimmt werden.

Derartige Verfahren sind beispielsweise aus dem Aufsatz von L.S. Davis "A Survey of Edge Detection Techniques" in "Computer Graphics and Image Processing" 1975, Nr. 4, Seiten 248-270 bekannt. Dabei werden verschiedene lineare oder nichtlineare Operatoren verwendet, die verschiedene Vorteile haben und unterschiedlichen Rechenaufwand erfordern. Insbesondere bei Anwendung von realen, mit Rauschen und Störsignalen behafteten Bildern zeigen die einzelnen Verfahren unterschiedliche Ergebnisse. Solche Bilder können beispielsweise Röntgenbilder oder mit Hilfe des magnetischen Kernresonanzverfahrens gewonnene Bilder sein. Bei Bildern aus der Praxis tritt nun das Problem auf, daß Kanten nicht genau auf einen Punkt bzw. eine mehr oder weniger strenge Folge von einzelnen Bildpunkten festgelegt werden können, und andererseits entstehen bei den bekannten Verfahren in den festgestellten Kanten häufig Lücken, d.h. nicht durchgehende Konturen.

JP-A-63,081,579 beschreibt ein Verfahren zur vereinfachten Berechnung der Grauwertverläufe bei Kantenbestimmung. Systems and Computers in Japan, Band 18, NR. 8, August 1986, Seiten 1165-1171; TSUTOMU HORIKOSHI: "Image Processing Algorithm for Edge-Line extraction of Limph Vessel Wall and Measurement of the Vessel Diameter" beschreibt ein Verfahren zur Erkennung der Wände eines Lymphgefäßes durch Kantenbestimmung.

Aufgabe der Erfindung ist es daher, ein Verfahren der eingangs genannten Art anzugeben, bei dem eine möglichst lückenlose, durchlaufende Kante in möglichst genauer Lage entsprechend dem realen Bild bestimmt werden kann.

Gemäß dem kennzeichnenden Teil des Anspruchs 1 wird diese Aufgabe dadurch gelöst, daß in der gefilterten Bildmatrix in vier um je 45° zueinander geneigte Richtungen getrennt lokale Minima und Maxima der Grauwerte bestimmt und gespeichert werden, daß nach Bestimmung aller Maxima und Minima in der gefilterten Bildmatrix zwischen jeweils einem Minimum und einem benachbarten Maximum in der ungefilterten Bildmatrix der tatsächliche Verlauf der Grauwertänderung in der betreffenden Richtung durch eine vorgegebene Funktion mit einem Wendepunkt angenähert wird, und daß die Lage des Wendepunktes einen Punkt einer gesuchten Kante darstellt.

Durch die Untersuchung des Bildes in vier verschiedenen Richtungen, d.h. praktisch in waagerechter und senkrechter Richtung sowie in beiden Diagonalen, wird jede auch weniger ausgeprägte Kante in der Richtung gefunden, die im wesentlichen senkrecht zu dieser Kante liegt. Ferner werden dadurch, daß die genaue Lage der tatsächlichen Kante im realen, ungefilterten Bild gesucht wird, Verschiebungen durch den Filterungsprozeß eliminiert. Auf diese Weise werden praktisch immer durchlaufende, ununterbrochene Kanten bestimmt. Dabei können zunächst alle Maxima und Minima in dem gefilterten Bild bestimmt und dann erst die Kantenpunkte im ungefilterten Bild ermittelt werden, oder es wird nach jeweils einem Paar von einem Maximum und einem Minimum der zugehörige Kantenpunkt ermittelt.

Die Funktion, die zur Annäherung der realen Grauwertänderung verwendet wird, kann beliebige Form haben, soweit sie einen Bereich mit einem Wendepunkt aufweist. Besonders zweckmäßig wird dafür nach einer ersten Ausgestaltung der Erfindung eine Sinus-Funktion verwendet. Nach einer anderen Ausgestaltung der Erfindung wird eine arctg-Funktion verwendet. Die Sinus-Funktion wird dabei zweckmäßig über eine halbe Periode von einem Minimum bis zum folgenden Maximum verwendet, während bei der arctg-Funktion ein entsprechender Bereich symmetrisch zum Wendepunkt verwendet wird. Auch andere Funktionen, d.h. ungerade Polynome höherer Ordnung, können verwendet werden.

Die Annäherung der Grauwertänderung im realen Bild kann auf verschiedene Weise erfolgen. Zweckmäßig ist die übliche Methode des kleinsten Fehlerquadrates.

Mit dem erfindungsgemäßen Verfahren werden die Kanten im Bild bildpunktweise bestimmt. Eine noch genauere Bestimmung ist dadurch möglich, daß nach einer weiteren Ausgestaltung der Erfindungaus den Steilheiten der annähernden Funktionen für alle Richtungen, in denen an einem Kantenpunkt diese Funktion einen Wendepunkt aufweist, eine Angabe über die Richtung der Kante abgeleitet wird. Diese Angaben über die Richtung der Kante können für weitere Aussagen verwendet werden.

Eine Anordnung zur Durchführung des erfindungsgemäßen Verfahrens ist im Anspruch 5 gekennzeichnet.

Ausführungsbeispiele der Erfindung werden nachstehend anhand der Zeichnung näher erläutert. Es zeigen
- Fig. 1: schematisch eine Bildmatrix mit den Abtastrichtungen,
- Fig. 2: den Verlauf der Grauwerte bei einer Abtastung der Bildmatrix in einer der Richtungen,
- Fig. 3: die Annäherung des tatsächlichen Bildes im Bereich einer Kante durch eine vorgegebene Funktion.
- Fig. 4: ein schematisches Blockschaltbild einer Anordnung zur Ermittlung von Kanten in einem Bild.

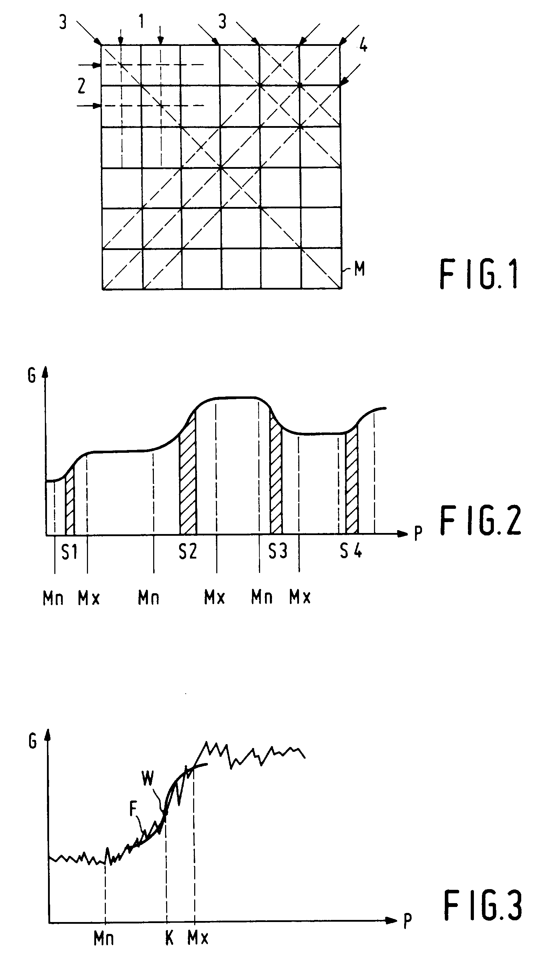

In Fig. 1 ist eine Bildmatrix M gezeigt, die aus einer Anzahl in Reihen und Spalten angeordneter Bildpunkte besteht, wobei jedes Quadrat einen Bildpunkt darstellen möge. Jeder Bildpunkt hat nun einen bestimmten Grauwert, der durch eine mehrstellige Binärzahl dargestellt ist. Es ist klar, daß im praktischen Fall die Bildmatrix M eine sehr viel größere Anzahl von Bildpunkten aufweist als in Fig. 1 dargestellt.

Da in der Praxis der Verlauf der Grauwerte in einem Bild unvermeidbar mit Rauschen und anderen Störsignalen überlagert ist, die falsche Kanten vortäuschen können, muß der Verlauf der Grauwerte in diesem Bild zunächst geglättet werden. Dabei wird vorzugsweise eine zweidimensionale Glättung verwendet, z.B. in üblicher Weise gemäß einer zweidimensionalen Gauss-Kurve. Die Standard-Abweichung der Gauss-Kurve wird so gewählt, daß die Störsignale weitgehend beseitigt werden, ohne daß steile Kanten oder dicht benachbarte Kanten zu sehr verschliffen werden.

Es sei nun angenommen, daß die Bildmatrix M in Fig. 1 den geglätteten Verlauf der Grauwerte enthält. Nun wird diese Matrix in verschiedenen Richtungen abgetastet, und zwar spaltenweise in Richtung der Pfeile 1 ferner zeilenweise entsprechend den Pfeilen 2 und außerdem in den beiden Diagonalen entsprechend den Pfeilen 3 und 4, wobei hier der Übersichtlichkeit halber bei nur einem Teil der abgetasteten Spalten und Zeilen und Diagonalen die Pfeile angegeben sind.

Der Vollständigkeit halber sei erwähnt, daß diese Abtastungen selbstverständlich nicht in einem realen Bild, sondern in den Folgen von in einem elektronischen Speicher gespeicherten Grauwerten des Bildes, ebenso wie die Glättung bzw. der Filtervorgang, mit gespeichert vorliegenden Bildsignalen vorgenommen wird.

In jeder Richtung ergeben sich also Folgen von Grauwerten, von denen ein Beispiel der Grauwerte G einer Abtastreihe von Bildpunkte P in Fig. 2 dargestellt ist. Dabei ist die tatsächlich vorhandene Folge von diskreten Grauwerten hier der Einfachheit halber als eine geschlossene Kurve dargestellt.

In dieser Kurve werden nun die lokalen Minima Mn und Maxima Mx auf herkömmliche Weise bestimmt. Zwischen jeweils einem Minimum und einem Maximum (oder umgekehrt) liegt ein Bereich S1, S2, S3 oder S4, in dem eine Kante mehr oder weniger steil geschnitten wird.

Um die genaue Lage dieser Kante zu ermitteln, wird jeweils zwischen einem Minimum Mn und einem benachbarten Maximum Mx, d.h. zwischen den zugehörigen Bildpunkten P, der Verlauf der Grauwerte in dem tatsächlichen, rausch- und störbehafteten Bild mittels einer Kurve mit einem Wendepunkt angenähert, wie dies in Fig. 3 angedeutet ist. Diese Fig. 3 zeigt beispielsweise einen über die Bildpunkte P gestreckten Verlauf der Grauwerte, die in Fig. 2 links geglättet dargestellt sind. Die Kurve F, die den tatsächlichen Verlauf der Grauwerte annähern soll, ist hier beispielsweise eine Sinusfunktion zwischen dem Minimum und dem Maximum, wobei auch beispielsweise eine arctg-Funktion in einem vorgegebenen Bereich verwendet werden kann. Die Funktion F wird nun derart verändert und in Richtung der Grauwerte G und in Richtung der Bildpunkte P verschoben, daß das mittlere Fehlerquadrat der Abweichungen der Grauwerte des störbehafteten Bildes von dieser Funktion ein Minimum wird. Wenn dies geschehen ist, gibt der Wendepunkt W der Funktion F die Lage, d.h. den Bildpunkt K an, auf dem die Kante einer Kontur im betreffenden Bildbereich liegt. Auf diese Weise wird eine Verschiebung des gefilterten Bildes bzw. des daraus gewonnenen Verlaufs der Grauwerte gegenüber dem ungefilterten Bild vermieden, d.h. die Kante wird dort ermittelt, wo sie im Originalbild tatsächlich am wahrscheinlichsten liegt.

Wenn eine Kante im Bild und damit auch im gefilterten Bild in verschiedenen Richtungen geschnitten wird, ergibt dies für die betreffenden Richtungen im wesentlichen bei demselben Bildpunkt eine Kante. Die Steilheit dieser Kante ist jedoch von der Richtung abhängig, in der die Kante geschnitten wird, d.h. senkrecht zur Kante ergibt sich die steilste Änderung des Grauwertverlaufs. Die Steilheit der Änderung des Grauwertverlaufs im Bereich der Kante ist nun in der Steilheit der Funktion F enthalten, die den Grauwertverlauf annähert, und ergibt sich aus der Steilheit dieser Funktion im Wendepunkt aus der Amplitude und der Periode dieser Funktion F. Aus den Steilheiten der Funktionen der verschiedenen Richtungen in einem als Kantenpunkt festgestellten Bildpunkt kann nun die Richtung der Kante ermittelt werden. Diese Richtung kann für eine eventuelle genauere Bestimmung der Kante beispielsweise durch Ausschalten von Mehrdeutigkeiten mit verwendet werden.

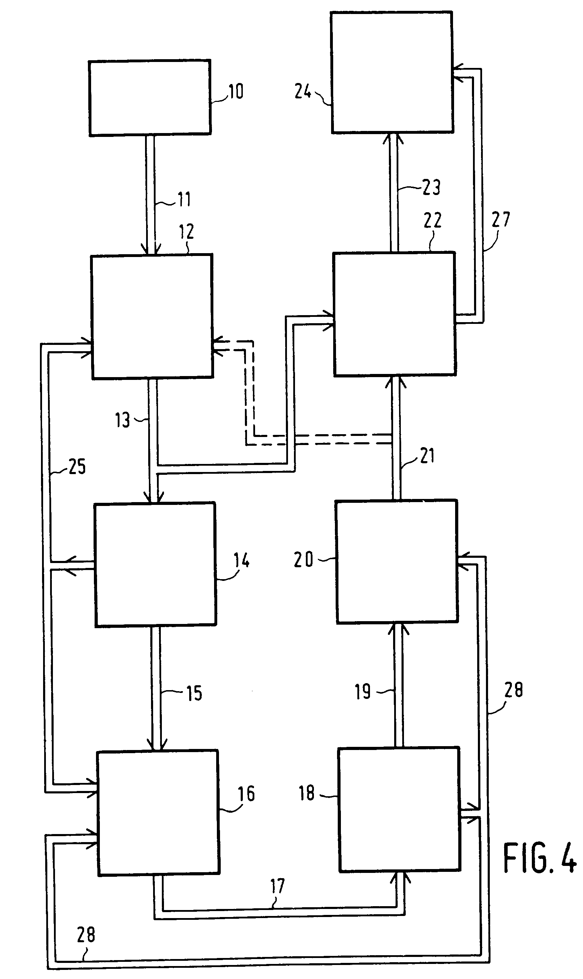

Die in Fig. 4 dargestellte Anordnung zur Kantenbestimmung enthält vier Speicher 12, 16, 20 und 24, drei Verarbeitungsanordnungen 14, 18 und 22 sowie einen Bildaufnehmer 10. Dieser Bildaufnehmer 10 nimmt das Bild, in dem Kanten bestimmt werden sollen, beispielsweise ein Röntgenbild, bildpunktweise auf und digitalisiert die Grauwerte der einzelnen Bildpunkte, und die digitalen Grauwerte werden über die Verbindung 11 einem Speicher 12 zugeführt, wo die Grauwerte zweckmäßig entsprechend der Bildpunktmatrix des vom Bildaufnehmer 10 aufgenommenen Bildes gespeichert werden. Die im Speicher 12 gespeicherten Bildpunktwerte sind noch mit Störungen und Rauschen behaftet.

Nach Aufnahme eines vollständigen Bildes adressiert eine Verarbeitungsanordnung 14 jeweils einen Teilbereich der Bildmatrix und führt eine Filterung der über die Verbindung 13 ausgegebenen Grauwerte durch, vorzugsweise gemäß einer zweidimensionalen Gaussfunktion. Die gefilterten Grauwerte werden über die Verbindung 15 einem zweiten Speicher 16 zugeführt und dort in entsprechender Weise wie im Speicher 12 abgespeichert, d.h. der Grauwert eines Bildpunktes im Speicher 12 entspricht einem unter Berücksichtigung der Grauwerte der umgebenden Bildpunkte gefilterten Grauwert im Speicher 16. Dafür werden beide Speicher 12 und 16 durch die Verarbeitungsanordnung 14 über die Verbindung 25 adressiert.

Nach der Filterung des zu untersuchenden Bildes beginnt eine Extremwertanordnung 18 zu arbeiten, die über die Verbindung 28 die gefilterten Grauwerte aus dem Speicher 16 ausliest, und zwar nacheinander in vier Adressenfolgen entsprechend den vier verschiedenen Richtungen in der Bildmatrix, die in Fig. 1 dargestellt sind. Die über die Verbindung 17 ausgelesenen Folgen von Grauwerte werden in der Extremwertanordnung 18 auf Maxima und Minima untersucht, wobei ein bestimmter Bildpunkt ein Maximum darstellt, wenn dessen Grauwert größer ist als der in der Abtastrichtung vorhergehende und folgende Grauwert. Gegebenenfalls kann zur Ermittlung ausgeprägter Extremwerte vorgeschrieben werden, daß die Unterschiede der Grauwerte zum vorhergehenden und zum folgenden Bildpunkt eine bestimmte Größe überschreiten müssen.

Sobald ein Minimum oder ein Maximum gefunden ist, wird eine entsprechende Markierung über die Verbindung 19 abgegeben und in einen dritten Speicher 20 eingeschrieben, der praktisch eine Anzahl Speicherplätze entsprechend vier Bildmatrizen aufweist, wobei jeder Speicherplatz nur zwei Bit speichern muß zur Kennzeichnung, ob an einem bestimmten Speicherplatz, d.h. an einem bestimmten Bildmatrixpunkt, ein Minimum, ein Maximum oder keines von beiden aufgetreten. Dazu wird dieser Speicher 20 ebenfalls über die Verbindung 28 von der Extremwertanordnung 18 adressiert, wobei zusätzlich jedoch noch die Matrix für die momentan gerade untersuchte Richtung angegeben werden muß.

Statt dessen kann im Speicher 20 auch nur der Koordinatenwert und die Richtung eines Maximums oder Minimums sowie dessen Angabe gespeichert werden. Dies erfordert zwar weniger Speicherplätze, da die meisten Bildmatrixpunkte keinen Extremwert darstellen, jedoch muß jeder Speicherplatz dann entsprechend mehr Bit speichern.

Im folgenden wird nun davon ausgegangen, daß zunächst alle Maxima und Minima der Bildmatrix in allen Richtungen ermittelt und dann erst die Annäherungen der realen Bildverläufe an das tatsächliche ungefilterte Bild vorgenommen werden. Dazu wird von einer Annäherungsanordnung 22 der Speicher 20 ausgelesen und die zwischen jeweils zwei aufeinanderfolgenden Extremwerten liegenden Bildpunktkoordinaten über die Verbindung 21 dem Speicher 12 mit der ungefilterten Bildmatrix als Adressen zugeführt, und die nun erneut ausgelesenen Folgen von Grauwerten, die über die Verbindung 13 abgegeben werden, werden der Annäherungsanordnung 22 zugeführt. Jede dieser Folgen von Grauwerten zwischen zwei Extremwerten wird in der Annäherungsanordnung 22 mittels einer Funktion angenähert, die einen eindeutigen Wendepunkt aufweist, beispielsweise eine Sinusfunktion oder eine arctg-Funktion, wobei die Annäherung zweckmäßig nach der Methode des kleinsten Fehlerquadrates erfolgt. Bei optimaler Annäherung fällt der Wendepunkt dieser optimal annähernden Funktion auf einen Bildpunkt, und für die Koordinaten dieses Bildpunktes, die von der Annäherungsanordnung 22 über die Verbindung 27 als Adresse an einen Speicher 24 abgegeben werden, werden in diesen Speicher über die Verbindung 23 entsprechende Markierungen eingeschrieben. Gegebenenfalls können zusätzlich zu diesen Markierungen auch die über den Ausgang 13 abgegebenen Grauwerte der Bildpunkte in den Speicher 24 eingeschrieben werden, so daß dieser schließlich das ursprüngliche Bild enthält, jedoch nunmehr mit markierten Kanten. Der Inhalt dieses Speichers kann nun beispielsweise auf einer Darstellungsanordnung, z.B. einem Bildgerät, dargestellt werden.

Es ist klar, daß die Filteranordnung 14, die Extremwertanordnung 18 und die Annäherungsanordnung 22 durch einen einzigen Rechner realisiert werden können. Entsprechend können auch insbesondere die Speicher 12, 16 und 20 lediglich Bereiche eines entsprechend größeren einheitlichen Speichers sein.

## Patentansprüche

1. Verfahren zum Bestimmen von Kanten in Bildern, die als Grauwerte von in einer zweidimensionalen Bildmatrix angeordneten Bildpunkten vorliegen, wobei die Grauwertverläufe dieser Bildmatrix mit Hilfe eines Operators gefiltert werden und in der gefilterten Bildmatrix durch Verknüpfung der Grauwerte jeweils mehrerer benachbarter Bildpunkte Kanten bestimmt werden, dadurch gekennzeichnet, daß in der gefilterten Bildmatrix in vier um je 45^{o} zueinander geneigte Richtungen getrennt lokale Minima und Maxima der Grauwerte bestimmt und gespeichert werden, daß nach Bestimmung aller Maxima und Minima in der gefilterten Bildmatrix zwischen jeweils einem Minimum und einem benachbarten Maximum in der ungefilterten Bildmatrix der tatsächliche Verlauf der Grauwertänderung in der betreffenden Richtung durch eine vorgegebene Funktion mit einem Wendepunkt angenähert wird, und daß die Lage des Wendepunktes einen Punkt einer gesuchten Kante darstellt.

2. Verfahren nach Anspruch 1,
dadurch gekennzeichnet, daß die vorgegebene Funktion eine Sinus-Funktion ist.

3. Verfahren nach Anspruch 1,
dadurch gekennzeichnet, daß die vorgegebene Funktion eine arctg-Funktion ist.

4. Verfahren nach einem der Ansprüche 1 bis 3,
dadurch gekennzeichnet, daß aus den Steilheiten der annähernden Funktionen für alle Richtungen, in denen an einem Kantenpunkt diese Funktion einen Wendepunkt aufweist, eine Angabe über die Richtung der Kante abgeleitet wird.

5. Anordnung zum Bestimmen von Kanten in Bildern nach dem Verfahren gemäß einem der Ansprüche 1 bis 4, mit einem ersten Speicher (12) zum Speichern von Grauwerten, die in einer zweidimensionalen Bildmatrix angeordnete Bildpunkte angeben, und mit einem mit dem Speicher verbundenen Rechner (14,18,22) zur Filterung der Grauwertverlaüfe und zum Speichern der gefilterten Grauwertverläufe in Speicherplätze eines zweiten Speichers (16), die als eine zweidimensionale gefilterte Bildmatrix angeordnet sind,
dadurch gekennzeichnet, daß der Rechner (14,18,22) in der gefilterten Bildmatrix im zweiten Speicher (16) in vier um je 45° zueinander geneigte Richtungen getrennt lokale Minima und Maxima der Grauwerte bestimmt und in einem dritten Speicher (20) speichert, daß, nach Bestimmung aller Maxima und Minima in der gefilterten Bildmatrix, der Rechner (14,18,22) zwischen jeweils einem Minimum und einem benachbarten Maximum in der ungefilterten Bildmatrix den tatsächlichen Verlauf der Grauwertänderung in der betreffenden Richtung durch eine vorgegebene Funktion mit einem Wendepunkt annähert und die Lage des Wendepunktes als einen Punkt einer gesuchten Kante in einem vierten Speicher (24) speichert.

6. Anordnung nach Anspruch 5,
dadurch gekennzeichnet, daß die vorgegebene Funktion eine Sinusfunktion ist.

7. Anordnung nach Anspruch 5,
dadurch gekennzeichnet, daß die vorgegebene Funktion eine arctg-Funktion ist.

8. Anordnung nach einem der Ansprüche 5 bis 7,
dadurch gekennzeichnet, daß der Rechner aus den Steilheiten der annähernden Funktionen für alle Richtungen, in denen an einem Kantenpunkt diese Funktion einen Wendepunkt aufweist, eine Angabe über die Richtung der Kante ableitet.

## Claims

1. A method of detecting edges in images which occur as grey-levels of pixels arranged in a two-dimensional image matrix, the grey-level variations of said image matrix being filtered by means of an operator and edges being detected in the filtered image matrix by combination of the grey-levels of each time several neighbouring pixels, characterized in that in the filtered matrix local minima and maxima of the grey levels are determined and stored separately in four directions which extend at an angle of 45 with respect to one another, that after determination of all maxima and minima in the filtered image matrix the actual grey-level variation in the relevant direction is approximated between each time a minimum and a neighbouring maximum in the non-filtered image matrix by way of a predetermined function having an inflection point, and that the location of the inflection point represents a point of an edge searched.

2. A method as claimed in Claim 1, characterized in that the predetermined function is a sine function.

3. A method as claimed in Claim 1, characterized in that the predetermined function is an arctg function.

4. A method as claimed in any one of the Claims 1 to 3, characterized in that an indication concerning the direction of the edge is derived from the slopes of the approximative functions for all directions in which this function exhibits an inflection point at an edge point.

5. An apparatus for detecting edges in images by means of the method claimed in any one of the Claims 1 to 4, comprising a first memory (12) for storing grey levels associated with pixels arranged in a two-dimensional image matrix, and also comprising a computer (14, 18, 22) which is connected to the memory for the filtering of the grey level variations and for storing the filtered grey-level variations in storage locations of a second memory (16) which are arranged as a two-dimensional filtered image matrix, characterized in that the computer (14, 18, 22) determines local minima and maxima of the grey levels separately in four directions which extend at an angle of 45 with respect to one another in the filtered image matrix in the second memory (16) for storage in a third memory (20), approximates the actual grey-level variation in the relevant direction between each time a minimum and a neighbouring maximum in the non-filtered image matrix, after determination of all maxima and minima in the filtered image matrix, by way of a predetermined function having an inflection point, and stores the location of the inflection point as a point of an edge searched, in a fourth memory (24).

6. An apparatus as claimed in Claim 5, characterized in that the predetermined function is a sine function.

7. An apparatus as claimed in Claim 5, characterized in that the predetermined function is an arctg function.

8. An apparatus as claimed in any one of the Claims 5 to 7, characterized in that the computer derives an indication concerning the direction of the edge from the slopes of the approximative functions for all directions in which this function exhibits an inflection point at an edge point.

## Revendications

1. Procédé de détermination de bords dans des images qui se présentent comme des valeurs de gris de pixels disposés dans une matrice d'image bidimensionnelle, les tracés des valeurs de gris de cette matrice d'image étant filtrés à l'aide d'un opérateur et les bords étant déterminés dans la matrice d'image filtrée par liaison des valeurs de gris de plusieurs pixels voisins, caractérisé en ce que, dans la matrice d'image filtrée, des minima et maxima locaux des valeurs de gris sont déterminés et sauvés séparément dans quatre directions décalées réciproquement de 45°, en ce qu'après la détermination de tous les maxima et minima dans la matrice d'image filtrée, le tracé effectif de la variation des valeurs de gris dans la matrice d'image non filtrée entre respectivement un minimum et un maximum voisin est approché dans la direction correspondante par une fonction prédéterminée avec un point d'inflexion et en ce que la position du point d'inflexion représente un point d'un bord recherché.

2. Procédé selon la revendication 1, caractérisé en ce que la fonction prédéterminée est une fonction sinus.

3. Procédé selon la revendication 1, caractérisé en ce que la fonction prédéterminée est une fonction arctg.

4. Procédé selon l'une des revendications 1 à 3, caractérisé en ce qu'une indication sur la direction du bord est déduite des pentes des fonctions d'approximation pour toutes les directions dans lesquelles cette fonction présente un point d'inflexion à un point du bord.

5. Dispositif de détermination de bords dans des images conformément au procédé selon l'une des revendications 1 à 4, avec une première mémoire (12) pour sauver des valeurs de gris qui indiquent des pixels disposés dans une matrice d'image bidimensionnelle et avec un ordinateur relié à la mémoire (14, 18, 22) pour le filtrage des tracés de valeur de gris et pour la sauvegarde des tracés de valeurs de gris filtrés dans les emplacements de mémoire d'une deuxième mémoire (16) qui sont disposés comme une matrice d'image filtrée bidimensionnelle, caractérisé en ce que l'ordinateur (14, 18, 22) dans la matrice d'image filtrée dans la deuxième mémoire (16) détermine dans quatre directions décalées réciproquement de 45° des minima et maxima locaux des valeurs de gris et les sauve dans une troisième mémoire (20), en ce que, après la détermination de tous les maxima et minima dans la matrice d'image filtrée, l'ordinateur (14, 18, 22) approche, entre respectivement un minimum et un maximum voisin dans la matrice d'image non filtrée, le tracé effectif de la variation de valeurs de gris dans la direction correspondante par une fonction prédéterminée avec un point d'inflexion et en ce que la position du point d'inflexion est sauvée comme un point d'un bord recherché dans une quatrième mémoire (24).

6. Dispositif selon la revendication 5, caractérisé en ce que la fonction prédéterminée est une fonction sinus.

7. Dispositif selon la revendication 5, caractérisé en ce que la fonction prédéterminée est une fonction arctg.

8. Dispositif selon l'une des revendications 5 à 7, caractérisé en ce qu'une indication sur la direction du bord est déduite par l'ordinateur des pentes des fonctions d'approximation pour toutes les directions dans lesquelles cette fonction présente un point d'inflexion sur un point du bord.
